# EUROPEAN PATENT APPLICATION

(11) **EP 4 729 289 A1**
(43) Date of publication of application: **22.04.2026**
(21) Application number: 24823369.4
(22) Date of filing: 11.06.2024
(51) Int. Cl.: B32B 15/04, B32B 15/08, B32B 15/20, B32B 27/18

(54) **BASE MATERIAL FOR MOUNTING ELECTRONIC DEVICE**

(30) Priority: 15.06.2023 JP 2023098776
(71) Applicant: Toyo Seikan Group Holdings, Ltd., Shinagawa-ku Tokyo 141-8627 (JP)
(72) Inventor: OKUYAMA, Shinpei, Tokyo 141-8627 (JP); OBU, Yusuke, Tokyo 141-8627 (JP); HAYASHI, Kenji, Tokyo 141-8627 (JP)
(74) Representative: J A Kemp LLP
(86) International application number: PCT/JP2024/021158
(87) International publication number: WO 2024/257753

(57) **Abstract**

A base material for mounting an electronic device, the base material including a metal foil (A), a hygroscopic layer, and a barrier sheet laminated in this order, in which the metal foil (A) has a thickness of from 5 to 20 µm.

## Description

### Technical Field

The present invention relates to a base material for mounting an electronic device, and more particularly, relates to a base material for mounting an electronic device, which is used for blocking and absorbing moisture to keep an electronic device in a dry state.

### Background Art

In the related art, a hygroscopic sheet including a hygroscopic resin layer in which a desiccant is dispersed has been widely used for moisture absorption and moisture prevention.

As such a hygroscopic sheet, those having various layer configurations have been proposed, and Patent Document 1 proposes a hygroscopic sheet including a desiccant layer, a moisture permeable sheet provided on one surface of the desiccant, and a pressure-sensitive adhesive layer provided on the other surface of the desiccant layer, and describes that a cellophane sheet, an acetate sheet, a nylon sheet, and the like are used as the moisture permeable sheet.

By the way, electronic devices developed in recent years, such as an organic electroluminescence (organic EL) display, a solar cell panel, a liquid crystal touch panel, and an electronic paper, are vulnerable to charge leakage, and thus high moisture barrier properties are required for plastic base materials forming the circuit boards and the like or plastic base materials such as films for sealing circuit boards.

However, the known hygroscopic sheet disclosed in Patent Document 1 and the like does not exhibit satisfactory performance as a sealing material for keeping the inside of the electronic device as described above in a dry state. That is, the desiccant present in the hygroscopic sheet reaches a saturated state in a short period of time by absorbing a large amount of moisture infiltrating from the outside of the device. The moisture absorbing property is impaired or the absorbed moisture is released into the device, and thus, further improvement is needed.

In addition, particularly, the structure of the electronic device is complicated, and thus, a bending stress may be applied to a plastic base material such as a sealing film at the time of installation, attachment, or the like, and even in a case where such a stress is applied, flexibility is required not to impair the moisture barrier properties.

Furthermore, in Patent Document 2, the present applicant has proposed a moisture barrier laminate (film) that stably exerts excellent barrier properties against moisture over a long period of time, which has been already patented.

The technology of Patent Document 2 is a technology that forms a thick organic layer being excellent in moisture diffusivity and having a thickness of 10 µm or more between an inorganic barrier layer and a hygroscopic layer disposed closer to a high-humidity atmosphere, thereby effectively suppressing deactivation of the hygroscopic layer and exerting excellent moisture barrier properties over a long period of time. That is, more than a few defects such as cracks are locally formed in the inorganic barrier layer, and moisture intensively flows into the hygroscopic layer through these defects, thereby accelerating wastage of the hygroscopic layer; however, in the technology of Patent Document 2, the organic layer having a large thickness (10 µm or more) rapidly diffuses the moisture flowing through the defects in the inorganic barrier layer, and hence, the disadvantage of locally concentrated moisture flow into the hygroscopic layer is effectively prevented, whereby the wastage of the hygroscopic layer is reduced, and excellent moisture barrier properties are exerted over a long period of time.

However, extended service life of the moisture barrier properties according to Patent Document 2 has its limit, and it is desired to exert the moisture barrier properties over a longer period of time.

### Citation List

### Patent Document

Patent Document 1: JP 2006-326838 A
Patent Document 2: JP 6657651 B

### Summary of Invention

### Technical Problem

The present invention is directed to providing a base material for mounting an electronic device, which can prevent permeation of moisture and keep the electronic device in a dry state and is excellent in flexibility.

### Solution to Problem

The present invention provides
a base material for mounting an electronic device, the base material including a metal foil (A), a hygroscopic layer, and a barrier sheet laminated in this order, in which
the metal foil (A) has a thickness of from 5 to 20 µm.

In the base material for mounting an electronic device of the present invention, the following aspects are suitable:
(1) the metal foil (A) is formed of aluminum;
(2) the hygroscopic layer contains a resin composition in which a hygroscopic agent (ii) is dispersed in an ionic polymer (i);
(3) the barrier sheet includes a resin layer, and has an inorganic barrier layer on at least one surface of the resin layer;
(4) the resin layer is formed of at least one of an olefin-based resin, a polyester resin, a polyimide resin, a polyamide resin, or a cyclic olefin-based resin;
(5) the inorganic barrier layer is formed of a vapor deposition film of a metal or a metal oxide;
(6) the barrier sheet has a metal foil (B) formed of aluminum, and the metal foil (B) has a thickness of from 5 to 20 µm;
(7) a quasi-hygroscopic layer is provided in at least one of a portion between the metal foil (A) and the hygroscopic layer or a portion between the hygroscopic layer and the barrier sheet;
(8) the quasi-hygroscopic layer is formed of at least one of an ionic polymer, a polyamide resin, a polyvinyl alcohol-based resin, or an ethylene-vinyl alcohol copolymer resin;
(9) an ultraviolet blocking layer is provided on a surface of either one of the metal foil (A) or the barrier sheet, the surface being on a side where the hygroscopic layer is not laminated; and
(10) an entire thickness is from 25 to 250 µm.

### Advantageous Effects of Invention

In the base material for mounting an electronic device of the present invention, the metal foil (A) blocks permeation of most of moisture, and even a trace amount of moisture that has permeated through pinholes of the metal foil (A) is absorbed by the hygroscopic layer. In addition, the barrier sheet is further provided on the surface of the hygroscopic layer on the device side, and the permeation of moisture that has not been absorbed by the hygroscopic layer is blocked. As a result, it is possible to prevent moisture from entering the device and to keep the device in a dry state for a long period of time.

In another aspect of the base material for mounting an electronic device of the present invention, the barrier sheet blocks permeation of most of moisture, and even a trace amount of moisture having permeated through the barrier sheet is absorbed by the hygroscopic layer. In addition, the metal foil (A) is further provided on the surface of the hygroscopic layer on the device side, and the permeation of moisture that has not been absorbed by the hygroscopic layer is blocked. As a result, it is possible to prevent moisture from entering the device and to keep the device in a dry state for a long period of time.

Furthermore, the base material for mounting an electronic device of the present invention has flexibility and is excellent in bending resistance. That is, the base material for mounting an electronic device of the present invention is easy to handle, and the moisture barrier properties of the base material is not impaired even when stress such as bending is applied.

In the present invention, the base material for mounting an electronic device is provided with a metal foil, and thus, is basically used in a portion where light transmittance of the device is not required (for example, a back sheet of a solar cell, another non-light receiving surface of a solar cell, a non-light emitting surface of an organic electroluminescent element, or a side surface of these devices).

### Brief Description of Drawings

FIG. 1 is a schematic cross-sectional view illustrating an example of a layer structure of a base material for mounting an electronic device of the present invention.
FIG. 2 is a schematic cross-sectional view illustrating another example of the layer structure of the base material for mounting an electronic device according to the present invention.
FIG. 3 is a schematic cross-sectional view illustrating still another example of the layer structure of the base material for mounting an electronic device according to the present invention.

### Description of Embodiments

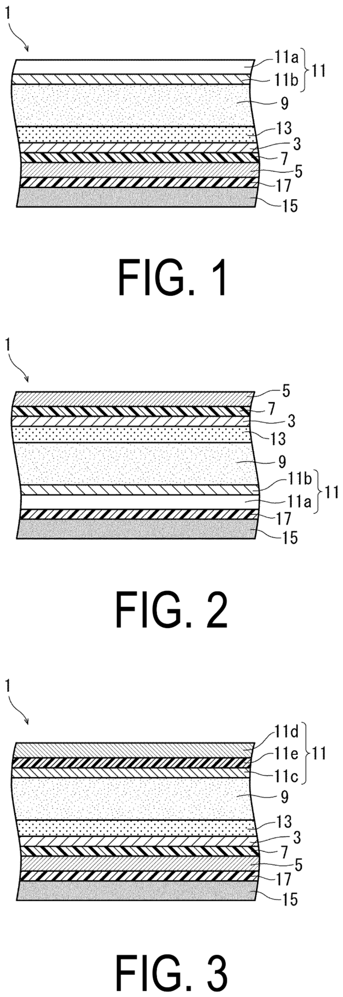

With reference to FIGS. 1 to 3, a base material for mounting an electronic device of the present invention, which is generally denoted by 1, has a metal foil (A) 3, a hygroscopic layer 9, and a barrier sheet 11 in this order.

### Metal Foil (A) 3

The metal foil (A) 3 is provided on one surface of the hygroscopic layer 9 on the outer surface side or the device side.

In a case where the metal foil (A) 3 is provided on the electronic device side of the hygroscopic layer 9, the metal foil (A) 3 has a role of blocking most of moisture (water vapor) that is to enter the device. In the case where the metal foil (A) 3 is provided on the electronic device side of the hygroscopic layer 9, the metal foil (A) 3 has a role of blocking moisture that has not been absorbed by the hygroscopic layer 9. As a result, the inside of the device can be kept in a dry state for a long period of time.

The metal foil (A) 3 is preferably formed of aluminum from the viewpoint of flexibility, ease of forming a thin film, or cost reduction.

The metal foil (A) 3 has a thickness of from 5 to 20 µm, more preferably from 6 to 20 µm, and particularly preferably from 6 to 15 µm. The metal foil (A) 3 having a thickness of less than 5 µm is difficult to produce. On the other hand, the metal foil (A) 3 having a thickness exceeding 20 µm has insufficient flexibility and is difficult to handle.

Here, the flexibility is also referred to as bending resistance, and refers to a property of having plasticity while having durability against bending or the like. The thinner the metal foil (A) 3, the more excellent the flexibility. In addition, the amount of the metal foil (A) 3 used can be reduced as the thickness is reduced, and thus, the production cost of the base material 1 as a whole can be reduced.

However, it is generally known that the number of pinholes increases when the metal foil (A) 3 becomes thinner. Accordingly, in a case where the thickness of the metal foil (A) 3 is small, the amount of moisture that permeates increases as compared with a case where the thickness of the metal foil (A) 3 is large, and there is a possibility that sufficient moisture barrier properties cannot be exhibited.

In the present invention, in a case where the metal foil (A) 3 is provided on the outer surface side of the hygroscopic layer 9, the hygroscopic layer 9 can absorb a trace amount of moisture that has permeated through the pinholes of the metal foil (A) 3, and thus, moisture permeation into the electronic device is prevented, and the electronic device can be maintained in a dry state. That is, most of moisture that is to enter the device from the outside is blocked by the metal foil 3, but a small amount of moisture that has permeated through the pinholes of the metal foil (A) 3 is also absorbed by the hygroscopic layer 9, and thus, the hygroscopic layer 9 compensates for the reduction in moisture barrier properties due to the small thickness of the metal foil (A) 3.

In addition, in a case where the metal foil (A) 3 is provided on the electronic device side of the hygroscopic layer 9, the metal foil (A) 3 has a role of blocking moisture that has not been absorbed by the hygroscopic layer 9. At this time, the amount of moisture reaching the metal foil 3 is extremely small, and there is almost no influence of moisture permeation due to an increase in pinhole caused by the small thickness of the metal foil (A) 3.

### Protective Resin Layer 5

A structure having only the metal foil (A) 3 may be adopted, but a protective resin layer 5 may be formed on the metal foil (A) 3 with an adhesive layer 7 interposed therebetween, which will be described below. The protective resin layer 5 is a resin layer provided for preventing the metal foil (A) 3 from being scratched or deteriorated by oxidation. Accordingly, particularly in a case where the metal foil (A) 3 is provided on the outer surface side of the hygroscopic layer 9, it is preferable to have the protective resin layer 5.

The protective resin layer 5 is formed using various resins known per se, and is generally formed of a polyester resin such as polyethylene terephthalate or a polyolefin-based resin such as polyethylene or polypropylene, and preferably a polyester resin.

Such a protective resin layer 5 only needs to have a thickness of from about 1 to 200 µm.

### Adhesive Layer 7

The adhesive layer 7 is a layer for bonding the metal foil (A) 3 and the protective resin layer 5.

An adhesive used for forming the adhesive layer 7 described above is suitably an epoxy-based adhesive or a urethane-based adhesive known as a dry laminate adhesive.

### Epoxy-based adhesive;

The epoxy-based adhesive noted above is an adhesive exerting adhesion when a liquid epoxy resin is cured with an epoxy curing agent.

The epoxy resin is a liquid resin having an epoxy group in the molecule, and typical examples thereof include those obtained by reaction of epichlorohydrin with a phenol compound, an amine compound, a carboxylic acid or the like, and those obtained by oxidation of an unsaturated compound such as butadiene with an organic peroxide or the like, and any type of epoxy resin can be used.

Specific examples of epoxy-based adhesive include, but are not limited to, bisphenol A type or bisphenol F type epoxy resins, novolac type epoxy resins, cyclic aliphatic type epoxy resins, long chain aliphatic type epoxy resins, glycidyl ester type epoxy resins, and glycidyl amine type epoxy resins.

In the present invention, a glycidylamine type epoxy resin is particularly suitable in terms that an adhesive layer 7 having a high elastic modulus can be formed.

Furthermore, as the epoxy curing agent, a known epoxy curing agent such as an amine-based curing agent, an acid anhydride, or a polyamide can be used, and an amine-based curing agent, in particular, an aromatic polyamine such as meta-phenylenediamine is suitably used from the viewpoint that a coating film (adhesive layer 7) having a particularly high elastic modulus and easily conforming to thermal shrinkage can be formed.

The ratio between the amount of the epoxy resin and the amount of the curing agent needs to be set according to the epoxy equivalent of the epoxy resin so that a sufficient cured film is formed.

### Urethane-based adhesive;

The urethane-based adhesive includes a reaction product of polyisocyanate with or a polyol. This adhesive usually contains a known curing catalyst such as an amine-based catalyst, a metal catalyst, or a phosphoric acid-modified compound. The amount of the curing catalyst is set according to the type of the curing catalyst in such a manner that a dense cured film (adhesive layer 7) can be formed at a temperature and for a time not causing thermal deformation of the base resin.

The polyol used for forming the polyurethane adhesive is a compound having two or more OH groups per molecule, and typical examples thereof include the following compounds:
di-, tri-, tetra-, penta-, and hexa-hydroxy compounds;
polyester polyols containing two or more OH groups in one molecule;
polyether polyols containing two or more OH groups in one molecule;
polycarbonate polyols containing two or more OH groups in one molecule;
polycaprolactone polyols containing two or more OH groups in one molecule; and
polyacrylic polyols containing two or more OH groups in one molecule;

The most suitable polyol in the present invention is a polyester polyol.

The polyisocyanate to be reacted with the polyol is a compound having two or more NCO groups per molecule. Specific examples thereof include, but are not limited to, the following compounds:
aliphatic isocyanates such as ethylene diisocyanate, trimethylene diisocyanate, and tetramethylene diisocyanate;
alicyclic isocyanates such as isophorone diisocyanate, norbornane diisocyanate, bis(isocyanatomethyl) cyclohexane, and 2-isocyanatomethyl-3-(3-isocyanatopropyl)-5-isocyanatomethyl-bicyclo[2,2,1]-heptane;
aromatic isocyanates such as xylylene diisocyanate, bis(isocyanatoethyl)benzene, bis(isocyanatomethyl)naphthalene, and bis(isocyanatomethyl)diphenyl ether;
sulfur-containing aliphatic isocyanates such as thiodiethyl diisocyanate;
aliphatic sulfide-based isocyanates such as bis[2-(isocyanatomethylthio)ethyl] sulfide;
aromatic sulfide-based isocyanates such as diphenylsulfide-2,4'-diisocyanate;
aromatic disulfide-based isocyanates such as diphenyl disulfide-4,4'-diisocyanate;
aromatic sulfone-based isocyanates such as diphenylsulfone-4,4'-diisocyanate;
sulfonic acid ester-based isocyanates such as 4-methyl-3-isocyanatebenzenesulfonyl-4'-isocyanatephenol ester;
aromatic sulfonic acid amide-based isocyanates such as 4-methyl-3-isocyanatebenzenesulfonylanilide-3'-methyl-4'-isocyanate; and
sulfur-containing heterocyclic isocyanates such as thiophene-2,5-diisocyanate;

The polyisocyanate noted above is usually used in such an amount that the amount of isocyanate groups (NCO groups) is from about 0.8 to 1.2 mol per mole of the hydroxyl groups included in the aforesaid polyol.

The epoxy-based adhesive and the urethane-based adhesive described above are applied to a predetermined part using a volatile organic solvent such as a hydrocarbon-based, alcohol-based, ketone-based, ester-based, or ether-based solvent, and dried to form the adhesive layer 7. The adhesive layer 7 formed in this way is typically cured by being kept at a temperature of from about 30 to 50°C for 24 hours or longer.

The adhesive layer 7 has a thickness of 0.1 to 10 µm, and preferably from 2 to 6 µm. In a case where the thickness of the adhesive layer 7 is less than 0.1 µm, the adhesiveness between the layers may be insufficient. In a case where the thickness of the adhesive layer 7 exceeds 10 µm, the adhesiveness between the layers can be ensured, while the production cost is unnecessarily increased.

### Hygroscopic Layer 9

The hygroscopic layer 9 can also be referred to as a moisture trap layer. The hygroscopic layer 9 is a layer for absorbing a trace amount of moisture which has permeated through the metal foil (A) 3 or the barrier sheet 11 provided on the outer surface side thereof, and is a layer in which a hygroscopic agent is dispersed in a resin. In the present invention, most of the moisture that is to enter the device is blocked by the metal foil (A) 3 or the barrier sheet 11, and thus, the hygroscopic layer 9 is less likely to swell, which maintains the moisture absorption capacity of the hygroscopic layer 9 for a long period of time.

Such a hygroscopic layer 9 is a layer in which a hygroscopic agent is dispersed in a resin matrix, but is preferably a layer in which a hygroscopic agent is dispersed in an ionic polymer as described in the above-described Patent Document 2, in particular, in a case where a high barrier property against moisture is required, from the viewpoint of an excellent moisture capturing ability and effectively avoiding deformation such as swelling caused by moisture absorption.

The ionic polymer noted above is for forming the matrix of this hygroscopic layer 9, and examples thereof include: a cationic polymer having a cationic group (such as NH₂ group) as an ionic group; and an anionic polymer having an anionic group (such as COONa group, COOH group) as an ionic group, and as the adsorbent, an adsorbent having lower ultimate humidity than that of the ionic polymer is generally used.

That is, in the hygroscopic layer 9 whose matrix is the ionic polymer described above, a trace amount of moisture that has flowed through the metal foil (A) 3 or the barrier sheet 11 and entered the hygroscopic layer 9 is absorbed in this matrix (ionic polymer). That is, the matrix itself shows high hygroscopicity, and hence captures and absorbs moisture.

Meanwhile, in a case where moisture is merely absorbed in the matrix, the absorbed moisture is liable to be easily released due to an environmental change such as a temperature rise. In addition, moisture intrusion increases the space between the polymer molecules forming the matrix, and as a result, the hygroscopic layer 9 swells and a large increase in volume occurs. However, in a case where an adsorbent having ultimate humidity lower than that of the matrix (the ionic polymer) is dispersed, the moisture absorbed in the matrix is further captured by a hygroscopic agent having higher hygroscopicity (i.e., a lower level of ultimate humidity) than that of the matrix, and not only swelling due to the absorbed water molecules is effectively suppressed, but also the water molecules are confined in the hygroscopic layer 9, and as a result, the release of moisture from the hygroscopic layer 9 is also effectively prevented.

In this way, in a case where the hygroscopic layer 9 is formed by dispersing the hygroscopic agent in the ionic polymer, the hygroscopic layer 9 has a high hygroscopic ability together with a dual function of moisture capturing and confinement, and thus moisture can be captured even under an atmosphere of extremely low humidity, and moisture is captured at a speed sufficiently faster than a speed at which moisture permeates through the metal foil (A) 3 or the barrier sheet 11, and thus, significantly high moisture barrier properties can be achieved.

### Ionic polymer (cationic polymer);

In the present invention, among the ionic polymers used for forming the matrix as noted above, the cationic polymer is a polymer including a cationic group that can be positively charged in water, for example, a primary to tertiary amino group, a quaternary ammonium group, a pyridyl group, an imidazole group, a quaternary pyridinium, or the like in the molecule. Such a cationic polymer has a strong nucleophilic effect and supplements water by hydrogen bonds, and hence can form a matrix having hygroscopicity.

An acceptable amount of the cationic group in the cationic polymer is generally such that the water absorption rate (JIS K-7209-1984) of the hygroscopic matrix to be formed is 20% or more, particularly from 30% to 45% under an atmosphere of humidity of 80%RH and at 30°C.

Examples of the cationic polymer that can be used include those obtained by polymerizing or copolymerized together with another copolymerizable monomer as appropriate, at least one of cationic monomers typified by: amine-based monomers such as allylamine, ethyleneimine, vinylbenzyltrimethylamine, [4-(4-vinylphenyl)-methyl]-trimethylamine, and vinylbenzyltriethylamine; nitrogen-containing heterocyclic monomers such as vinylpyridine and vinylimidazole; and salts thereof, followed by partial neutralization by acid treatment if needed.

Note that, examples of the other copolymerizable monomer include, but are not limited to, styrene, vinyl toluene, vinyl xylene, α-methylstyrene, vinyl naphthalene, α-halogenated styrenes, acrylonitrile, acrolein, methyl vinyl ketone, and vinyl biphenyl.

Alternatively, instead of using the cationic monomer noted above, a monomer having a functional group to which a cationic functional group can be introduced, for example, styrene, bromobutylstyrene, vinyl toluene, chloromethylstyrene, vinyl pyridine, vinyl imidazole, α-methylstyrene, vinyl naphthalene, or the like is used, and a treatment such as amination or alkylation (quaternary ammonium chloride) can be implemented after polymerization to give a cationic polymer.

In the present invention, among the cationic polymers noted above, allylamine is particularly suitable from the viewpoint of film formability and the like.

The cationic polymer mentioned above is generally produced by radical polymerization by heating using a polymerization initiator, as described in Patent Document 2.

Note that, in the case where the polymerization is carried out using a monomer to which a cationic functional group can be introduced, a treatment to introduce a cationic group, such as amination or alkylation treatment, needs to be implemented after the polymerization.

In the present invention, a crosslinked structure is preferably introduced into a matrix that is formed using the aforesaid cationic polymer in order to ensure the mechanical strength without deteriorating its hygroscopic ability and at the same time to improve the dimensional stability.

That is, when a crosslinked structure is introduced into a hygroscopic matrix, the molecules of the cationic polymer are constrained to each other by crosslinking when the matrix absorbs water, which suppresses volume change due to swelling (moisture absorption), and provides improved mechanical strength and dimensional stability.

The crosslinked structure noted above can be introduced by blending a crosslinking agent into a coating composition for forming the hygroscopic layer 9.

As described in Patent Document 2, for such a crosslinked structure, there can be used a compound including a crosslinkable functional group (e.g., an epoxy group) capable of reacting with a cationic group, and a functional group (e.g., an alkoxysilyl group) capable of forming a siloxane structure in the crosslinked structure through hydrolysis and dehydration condensation, and particularly, a silane compound represented by the following formula (2) is suitably used: X-SiR¹ₙ(OR²)₃₋ₙ (2)
where X is an organic group having an epoxy group at its terminal,
R¹ and R² are each a methyl group, an ethyl group, or an isopropyl group, and
n is 0, 1, or 2. That is, the crosslinking agent is blended into the coating composition for forming a hygroscopic layer containing the cationic polymer and film formation is performed, thereby enabling introduction of a crosslinked structure.

### Ionic polymer (anionic polymer);

The anionic polymer used for forming a hygroscopic matrix is a polymer in which an anionic functional group that can be negatively charged in water, such as a carboxylic acid group, a sulfonic acid group, a phosphonic acid group, or an acidic base formed by partial neutralization of these groups is included in the molecule. The anionic polymer including such a functional group can form a hygroscopic matrix since the functional group supplements water by hydrogen bonds.

The amount of the anionic functional group in the anionic polymer varies depending on the type of the functional group, but as with the aforesaid cationic polymer, an acceptable amount thereof is such that the water absorption rate (JIS K-7209-1984) of the hygroscopic matrix to be formed is 20% or more, particularly from 30% to 45% under an atmosphere of humidity of 80%RH and at 30°C.

As the anionic polymer having such a functional group as noted above, examples thereof that can be used include those obtained polymerizing or copolymerized together with another copolymerizable monomer as appropriate, at least one of anionic monomers typified by: carboxylic acid-based monomers such as methacrylic acid, acrylic acid, and maleic anhydride; sulfonic acid-based monomer such as α-halogenated vinyl sulfonic acid, styrene sulfonic acid, and vinyl sulfonic acid; phosphonic acid-based monomer such as vinylphosphoric acid; and salts of these monomers, followed by partial neutralization by alkali treatment if needed.

Note that, examples of the other copolymerizable monomer include, but are not limited to, styrene, vinyl toluene, vinyl xylene, α-methylstyrene, vinyl naphthalene, α-halogenated styrenes, acrylonitrile, acrolein, methyl vinyl ketone, and vinyl biphenyl.

Alternatively, instead of using the anionic monomer noted above, an ester of the anionic monomer or a monomer having a functional group to which an anionic functional group can be introduced, such as styrene, vinyl toluene, vinyl xylene, α-methylstyrene, vinyl naphthalene, or α-halogenated styrenes can be used, and a treatment such as hydrolysis, sulfonation, chlorosulfonation, or phosphonium formation can be implemented after polymerization to give an anionic polymer.

In the present invention, suitable anionic polymers are poly(meth)acrylic acid and partially neutralized products thereof (e.g., those having a moiety that is a Na salt).

The anionic polymer mentioned above is generally produced by radically polymerizing a monomer having an anionic group by heating using a polymerization initiator. When a monomer to which an anionic functional group can be introduced is used as the monomer, a treatment to introduce an anionic group, such as hydrolysis, sulfonation, chlorosulfonation, or phosphonium formation, is required to be implemented after polymerization.

In the present invention, a crosslinked structure is particularly preferably introduced into the hygroscopic matrix formed using the aforesaid anionic polymer noted above, thereby further enhancing the moisture trap ability of the hygroscopic layer 5 and moreover providing further improvement in dimensional stability.

That is, in the case of the anionic polymer, unlike the cationic polymer, water is supplemented only by hydrogen bonds, and hence, a network structure (crosslinked structure) of spaces suitable for moisture absorption is introduced into the matrix, whereby the hygroscopicity can be greatly enhanced. Such a crosslinked structure has, for example, a hydrophobic site such as an alicyclic structure in the network structure, and as a result, the hygroscopic effect of the hydrophilic site is further enhanced.

Furthermore, introducing a crosslinked structure into the hygroscopic matrix causes the molecules of the anionic polymer to be constrained to each other by crosslinking when the matrix absorbs water, thereby suppressing the volume change due to swelling (moisture absorption) and improving the dimensional stability. Such an effect of improving the dimensional stability is the same as that in the case of the aforesaid cationic polymer described above.

As in the case of the cationic polymer, the crosslinked structure is introduced by blending a crosslinking agent into the coating composition for forming the hygroscopic layer 9. As described in Patent Document 2, this crosslinking agent is a compound having two or more crosslinkable functional groups (e.g., epoxy groups) capable of reacting with the ionic groups included in the anionic polymer, and is, for example, a diglycidyl ester represented by formula (1):

G-O(C=O)-A-(C=O)O-G (1)

where G is a glycidyl group, and
A is a divalent hydrocarbon group having an aliphatic ring, such as a cycloalkylene group. That is, the crosslinking agent is blended into the coating composition for forming a hygroscopic layer containing the anionic polymer and film formation is carried out, thereby enabling introduction of a crosslinked structure.

### Hygroscopic agent;

The hygroscopic agent, which is to be dispersed in the hygroscopic layer 9 whose matrix (hygroscopic matrix) is made of the ionic polymer mentioned above, has ultimate humidity lower than that of the ionic polymer (cationic or anionic polymer) forming the matrix noted above, and has extremely high hygroscopic performance. Dispersing the hygroscopic agent having hygroscopicity higher than that of the matrix in this manner causes moisture absorbed in the matrix formed of the aforesaid ionic polymer to be immediately captured by the hygroscopic agent, and the absorbed moisture is effectively confined in the matrix, and thus, not only the hygroscopic ability for moisture can be effectively exerted even in an extremely low humidity atmosphere, but also swelling of the hygroscopic layer 9 due to moisture absorption is effectively suppressed.

As the hygroscopic agent having high hygroscopicity as noted above, provided that the ultimate humidity is lower than that of the ionic polymer, a hygroscopic agent having ultimate humidity of 6% or less under environmental conditions of humidity of 80%RH and a temperature of 30°C is suitably used, for example, as shown in Examples described later. That is, when the ultimate humidity of this hygroscopic agent is higher than that of the ionic polymer, the moisture absorbed in the matrix is not sufficiently confined, and moisture release or the like is likely to occur, so that significant improvement in moisture barrier properties cannot be expected. Also, even when the ultimate humidity is lower than that of the ionic polymer, if the ultimate humidity measured under the conditions noted above is higher than the range noted above, for example, trapping of moisture in a low-humidity atmosphere becomes insufficient, and there is a concern that the moisture barrier properties are not fully exerted.

The hygroscopic agent as noted above generally has a water absorption rate (JIS K-7209-1984) of 50% or more in an atmosphere of humidity of 80%RH and a temperature of 30°C, and examples thereof include inorganic and organic hygroscopic agents.

Examples of the inorganic hygroscopic agent include zeolite, alumina, activated carbon, clay minerals such as montmorillonite, silica gel, calcium oxide, and magnesium sulfate.

Examples of the organic hygroscopic agent include a crosslinked product of an anionic polymer or of a partially neutralized product thereof. Examples of the anionic polymer include those obtained by polymerizing or copolymerizing with another monomer, at least one of anionic monomers typified by carboxylic acid-based monomers (such as (meth)acrylic acid, maleic anhydride), sulfonic acid-based monomers (such as halogenated vinylsulfonic acid, styrenesulfonic acid, vinylsulfonic acid), phosphonic acid-based monomers (such as vinyl phosphoric acid), and salts of these monomers. In an intended use where transparency is required in particular, an organic hygroscopic agent is effective. For example, fine particles of crosslinked sodium poly(meth)acrylate and the like are typical organic hygroscopic agents.

In the present invention, from the viewpoint of increasing the specific surface area and exhibiting high hygroscopicity, a hygroscopic agent having a small particle diameter is preferable (e.g., the average primary particle diameter is 100 nm or less, particularly 80 nm or less), and in particular, a hygroscopic agent of the organic polymer having a small particle diameter is the most suitable.

The hygroscopic agent of the organic polymer has very excellent dispersibility in the matrix of the ionic polymer, and can be uniformly dispersed. Furthermore, when emulsion polymerization, suspension polymerization, or the like is employed as a polymerization method for producing the moisture absorbing agent, particles can have a fine and uniform spherical shape. Blending the moisture absorbing agent of the organic polymer to some extent or more enables very high transparency to be secured.

Moreover, as for the organic fine hygroscopic agent, the aforesaid ultimate humidity is remarkably low, and not only high hygroscopicity is exhibited but also volume change due to swelling can be extremely small by virtue of crosslinking, and therefore the organic fine hygroscopic agent is the most suitable in reducing the humidity to an absolute dry state or to a state close to an absolute dry state while suppressing the volume change.

Examples of fine particles of such an organic hygroscopic agent include crosslinked sodium polyacrylate fine particles (average particle diameter: about 70 nm), which are commercially available in the form of a colloidal dispersion (pH = 10.4) from Toyobo Co., Ltd. under the trade name of TAFTIC HU-820E.

In the present invention, the amount of the hygroscopic agent as noted above is set according to the type of the ionic polymer from the viewpoint of sufficiently exerting the properties thereof, significantly improving the moisture barrier properties, effectively suppressing the dimensional change due to swelling, and at the same time, ensuring moisture barrier properties higher than the barrier properties exhibited by the metal foil (A) 3 or an inorganic barrier layer 11b over a long period of time.

For example, for the hygroscopic layer 9 in which the ionic polymer mentioned above is used as a matrix, and a hydroscopic agent is dispersed in the matrix, in a case where the matrix is formed of a cationic polymer, the hygroscopic agent is preferably present in an amount of 50 parts by weight or more, particularly from 100 to 900 parts by weight, and more preferably from 200 to 600 parts by weight per 100 parts by weight of the ionic polymer in the hygroscopic layer 9. In a case where the matrix is formed of an anionic polymer, the hygroscopic agent is preferably present in an amount of 50 parts by weight or more, particularly from 100 to 1300 parts by weight, and more preferably from 150 to 1200 parts by weight per 100 parts by weight of the anionic polymer in the hygroscopic layer 9.

The thickness of the hygroscopic layer 9 mentioned above varies depending on the intended use of the base material 1 for mounting an electronic device and the required level of barrier properties, but the thickness is only required to be set to from about 1 to 20 µm, particularly from about 1 to 15 µm in the case of ensuring a water vapor permeance of 10⁻² g/m²·day or less, particularly 10⁻³ g/m²·day or less. If the thickness is small, the amount of absorbed moisture reaches the upper limit in a short period of time, and the moisture barrier properties are compromised. In contrast, if the thickness is excessively large, the amount of moisture that can be absorbed increases, but the increased amount of the absorbed moisture increases the volume change due to swelling, and as a result, delamination is likely to occur.

### Barrier Sheet 11

The barrier sheet 11 is provided on the surface of the hygroscopic layer 9 opposite to the surface on which the metal foil (A) 3 is provided.

In a case where the barrier sheet 11 is provided on the outer surface side of the hygroscopic layer 9, the barrier sheet 11 has a role of blocking most of moisture (water vapor) that is to enter the device. On the other hand, in a case where the barrier sheet 11 is provided on the electronic device side of the hygroscopic layer 9, the barrier sheet 11 has a role of blocking moisture that has not been absorbed by the hygroscopic layer 9. In either case, as a result, the inside of the device can be kept in a dry state for a long period of time.

The barrier sheet 11 may have two aspects, i.e., an aspect having the inorganic barrier layer 11b on at least one surface of a resin layer 11a, and an aspect having a metal foil (B) 11c. The moisture barrier properties are exhibited by the inorganic barrier layer 11b or the metal foil (B) 11c.

### Resin Layer 11a

First, the aspect in which the barrier sheet 11 has the inorganic barrier layer 11b on at least one surface of the resin layer 11a will be described.

The resin layer 11a serves as a base of the inorganic barrier layer 11b, and is usually molded by injection or co-injection molding, extrusion or co-extrusion molding, film or sheet molding, compression molding, cast polymerization, or the like, depending on the form, using a thermoplastic or thermosetting resin. In general, a thermoplastic resin is suitable from the viewpoint of moldability and cost.

Examples of such a thermoplastic resin include the following:
olefin-based resins:
polyolefins such as low density polyethylene, high density polyethylene, polypropylene, poly(1-butene), poly(4-methyl-1-pentene), or random or block copolymers of α-olefins such as ethylene, propylene, 1-butene, and 4-methyl-1-pentene, further, cyclic olefin copolymers, and cyclic olefin polymers;
ethylene-vinyl compound copolymers:
   ethylene-vinyl acetate copolymer, ethylene-vinyl alcohol copolymer, ethylene-vinyl chloride copolymer, and the like;
   styrene-based resins:
      polystyrene, acrylonitrile-styrene copolymer, ABS, α-methylstyrene-styrene copolymer, and the like;
      polyvinyl compounds:
         polyvinyl chloride, polyvinylidene chloride, vinyl chloride-vinylidene chloride copolymer, polymethylacrylate, polymethyl methacrylate, and the like;
         polyamides:
            Nylon 6, Nylon 6-6, Nylon 6-10, Nylon 11, Nylon 12, and the like;
            thermoplastic polyesters:
               polyethylene terephthalate (PET), polybutylene terephthalate, polyethylene naphthalate (PEN), and the like;
               others:
                  polycarbonate, polyphenylene oxide, polyimide resin, polyamideimide resin, polyetherimide resin, fluorine resin, allyl resin, polyurethane resin, cellulose resin, polysulfone resin, polyethersulfone resin, ketone resin, amino resin, and biodegradable resins such as polylactic acid;

In addition, the thermoplastic resin may be a blend of the resins exemplified above, or a resin obtained by appropriately modifying any of these resins by copolymerization (for example, an acid-modified olefin resin).

The resin layer 11a can also be formed of a gas barrier resin or the like, such as an ethylene-vinyl alcohol copolymer, having excellent oxygen barrier properties, and may have a multilayer structure including a layer formed of such a gas barrier resin. That is, the inorganic barrier layer 11b can be formed on a base of the resin layer 11a containing such a gas barrier resin.

In the present invention, a film of a polyester resin such as polyethylene terephthalate (PET), polybutylene terephthalate, or polyethylene naphthalate, of a polyimide resin, or of a cyclic olefin-based resin such as a cyclic olefin copolymer or a cyclic olefin polymer is more suitably used as the resin layer 11a, from the viewpoint of availability, cost, moldability, or a certain degree of barrier properties against oxygen and moisture, and moreover from the viewpoint of suitability for a base of the inorganic barrier layer 11b to be described below.

The thickness of the above-described resin layer 11a is not particularly limited, but when this thickness is excessively large, the flexibility may be impaired or handling may become difficult. Accordingly, the thickness of the resin layer 11a is usually 200 µm or less, and more preferably 125 µm or less, and within this range, an appropriate moisture permeability can be ensured. Moreover, the thickness is preferably adjusted to such a thickness that allows the film formation of the inorganic barrier layer 11b to be performed effectively, for example, 20 µm or more.

### Inorganic Barrier Layer 11b

The inorganic barrier layer 11b is an inorganic matter vapor deposition film formed by physical vapor deposition typified by sputtering, vacuum deposition, ion plating, or the like, chemical vapor deposition typified by plasma CVD, or the like, examples thereof include a film formed of various metals or metal oxides, and a vapor deposition film (vapor deposition film of a metal or a metal oxide) formed by plasma CVD is preferable in terms of being evenly deposited even on uneven surfaces in particular and exerting excellent barrier properties not only against moisture but also against oxygen and the like. Such an inorganic barrier layer 11b is formed on the aforesaid resin layer 11a.

Note that the vapor deposition film by plasma CVD is obtained by a manner in which the resin layer 11a on which the inorganic barrier layer 11b is to be supported is disposed in a plasma processing chamber held at a predetermined degree of vacuum, a gas (reaction gas) of a metal to form a film or of a compound containing the metal and an oxidizing gas (usually oxygen or NOx gas) are fed together with a carrier gas such as argon or helium as appropriate through a gas supply line to the plasma processing chamber shielded by a metal wall and depressurized to the predetermined degree of vacuum, and in this condition, a glow discharge is created by a microwave electric field, a high-frequency electric field, or the like, plasma is generated by the electrical energy of the discharge and decomposition reaction products of the compound noted above are deposited on the surface of the plastic base material to form a film.

In a case of forming a film by a microwave electric field, the film is formed by irradiating the inside of the plasma processing chamber with microwaves through a waveguide or the like, and in a case of forming a film by a high-frequency electric field, the resin layer 11a in the plasma processing chamber is disposed to be positioned between a pair of electrodes, and a high-frequency electric field is applied across the electrodes to form the film.

As the reaction gas noted above, it is generally preferable to use a gas of an organometallic compound, for example, an organoaluminum compound such as trialkylaluminum, an organotitanium compound, an organozirconium compound, or an organosilicon compound from the viewpoint of being capable of forming a film including a flexible region containing a carbon component on the resin layer 11a and including a region having a high degree of oxidation and excellent barrier properties on the flexible region, and in particular, an organosilicon compound is most preferably used from the viewpoint of being capable of relatively easily and efficiently forming the inorganic barrier layer 11b with high barrier properties against oxygen.

Examples of such organosilicon compounds that are used include: organic silane compounds such as hexamethyldisilane, vinyltrimethylsilane, methylsilane, dimethylsilane, trimethylsilane, diethylsilane, propylsilane, phenylsilane, methyltriethoxysilane, vinyltriethoxysilane, vinyltrimethoxysilane, tetramethoxysilane, tetraethoxysilane, phenyltrimethoxysilane, methyltrimethoxysilane, and methyltriethoxysilane; and organic siloxane compounds such as octamethylcyclotetrasiloxane, 1,1,3,3-tetramethyldisiloxane, and hexamethyldisiloxane. Moreover, besides these, aminosilane, silazane, or the like can also be used.

The organometallic compounds mentioned above can be used singly, or two or more kinds thereof can be used in combination.

When forming a film by plasma CVD using the reaction gas of the organometallic compound and the oxidizing gas noted above, it is preferable that the glow discharge output (e.g., microwave or high-frequency output) be lowered, the film formation be started at low output, and then film formation be carried out by plasma reaction at high output.

That is, organic groups (such as CH₃, CH₂) contained in the molecules of the organometallic compound usually volatilize as CO₂, but at low output, some of the organic groups are not decomposed to CO₂, and are deposited on the surface of the resin layer and will be contained in the film. On the other hand, enhancing the output increases the organic groups decomposed to CO₂. Therefore, increasing the output enables reducing the C content in the film and forming a film with a high degree of oxidation of the metal contained in the organometallic compound. However, a film with a high degree of oxidation of the metal has extremely high barrier properties against gases such as oxygen, but is poor in flexibility and insufficient in adhesion to the resin layer, whereas a film with a low degree of oxidation of the metal and a high content of organic components has insufficient barrier properties against gases, but is highly flexible and exhibits high adhesion to the resin layer 11a.

As can be understood from the foregoing description, in the present invention, an organometallic compound is used as a reaction gas and film formation is carried out at a low output in the initial stage of film formation by plasma CVD and then the output is increased to perform film formation, whereby a high adhesion region containing a large amount of organic components (carbon) is formed in a portion in contact with the surface of the resin layer 11a, and a high gas barrier region with a high degree of oxidation of the metal is formed thereon.

Accordingly, to ensure excellent gas barrier properties, when a degree of oxidation of a metal (M) is represented by x (x = atomic ratio of O/M), the inorganic barrier layer 11b in the present invention preferably includes a high oxidation degree region in which the degree of oxidation x is from 1.5 to 2.0. In addition, an organic region having a carbon (C) concentration of 20 element% or more based on three elements of metal (M), oxygen (O), and carbon (C) is preferably formed on the lower side of this high oxidation degree region (the side in contact with the surface of the resin layer 11a). Furthermore, this metal (M) is most preferably silicon (Si).

Note that, the high oxidation degree region in the inorganic barrier layer 11b is preferably present at a percentage of 60% or more of the total thickness of the inorganic barrier layer 11b, and the organic region preferably has a thickness of from about 5 to 40% of the total thickness of the inorganic barrier layer 11b and is formed on the side in contact with the surface of the resin layer 11a.

When the inorganic barrier layer 11b including the organic region and the high oxidation degree region mentioned above is deposited by plasma CVD, the glow discharge output is slightly different between the case using microwaves and the case using high-frequency waves. For example, in the case using microwaves, the organic region is formed at a low output of from about 30 to 100 W, and the high oxidation degree region is deposited at a high output of 90 W or more. In the case using high-frequency waves, the organic region is formed at a low output of from about 20 to 80 W, and the high oxidation degree region is deposited at a high output of 100 W or more.

The deposition time needs to be set such that the thickness of each region is within the aforesaid range.

The total thickness of the inorganic barrier layer 11b mentioned above varies depending on the intended use of the base material 1 for mounting an electronic device or the required level of barrier properties, but the thickness should be generally adjusted to such a thickness that can ensure the water vapor permeance to be 10⁻² g/m²·day or less, and particularly 10⁻³ g/m²·day or less, and is generally only required to be from about 4 to 500 nm, and particularly from about 30 to 400 nm, although it varies depending on the proportion of the high oxidation degree region mentioned above.

### Metal Foil (B) 11c

Next, an aspect in which the barrier sheet 11 has the metal foil (B) 11c will be described.

For the metal foil (B) 11c, the same material as that of the metal foil (A) 3 can be used. That is, the material of the metal foil (B) 11c is preferably aluminum from the viewpoint of flexibility, ease of forming a thin film, or cost reduction.

The metal foil (B) 11c has a thickness of from 5 to 20 µm, more preferably from 6 to 20 µm, and particularly preferably from 6 to 15 µm. The metal foil (B) 11c having a thickness of less than 5 µm is difficult to produce. On the other hand, the metal foil (B) 11c having a thickness exceeding 20 µm has insufficient flexibility, and is difficult to handle.

Note that in a case of using the metal foil (B) 11c, the base material 1 has two metal foils, i.e., the metal foil (A) 3 and the metal foil (B) 11c. When the base material 1 having such a configuration is mounted on an electronic device, there is a possibility that a failure due to energization occurs, and thus, it is necessary to apply the base material 1 in consideration of the type of the electronic device, the use environment, and the like.

### Protective Resin Layer 11d

A structure having only the metal foil (B) 11c may be adopted, but a protective resin layer 11d may be formed on the metal foil (B) 11c with an adhesive layer 11e interposed therebetween, which will be described below. For the protective resin layer 11d, the same material as that of the protective resin layer 5 can be used.

The protective resin layer 11d is a resin layer provided for preventing the metal foil (B) 11c from being scratched or degraded by oxidation. Thus, particularly in a case where the metal foil (B) 11c is provided on the outer surface side of the hygroscopic layer 9, it is preferable to have the protective resin layer 11d.

The protective resin layer 11d is formed of various resins known per se, and is generally formed of a polyester resin such as polyethylene terephthalate, or an olefin-based resin such as polyethylene or polypropylene, particularly a polyester resin.

Such a protective resin layer 11d only needs to have a thickness of from about 1 to 200 µm.

### Adhesive Layer 11e

The adhesive layer 11e is a layer for bonding the metal foil (B) 11c and the protective resin layer 11d. For such an adhesive layer 11e, the same material as that of the adhesive layer 7 can be adopted.

### Quasi-Hygroscopic Layer 13

In the present invention, a quasi-hygroscopic layer 13 is a layer exhibiting a certain degree of hygroscopicity, although not as high as that of the hygroscopic layer 9. The quasi-hygroscopic layer 13 can be provided in at least one of a portion between the metal foil (A) and the hygroscopic layer or a portion between the hygroscopic layer and the barrier sheet.

In the present invention, the quasi-hygroscopic layer 13 is formed only of a resin without blending a hygroscopic agent. Such a quasi-hygroscopic layer 13 can be formed at a lower cost than the hygroscopic layer 9 because no hygroscopic agent is blended.

Examples of the resin that is used to form the quasi-hygroscopic layer 13 include an ionic polymer having a lower concentration of cationic groups or anionic groups as compared with the ionic polymer used to form the hygroscopic layer 9, and in particular, an ionic polymer, a polyamide resin, a polyvinyl alcohol-based resin, an ethylene-vinyl alcohol copolymer resin, and the like are suitable, and polyamide are suitable, and a polyamide resin is most suitable.

Typical examples of such polyamides include Nylon 6, Nylon 6-6, Nylon 6-10, Nylon 11, and Nylon 12.

The thickness of the quasi-hygroscopic layer 13 mentioned above is preferably less than 150 µm, and particularly within a range of from 2 to 100 µm. If the thickness is larger than necessary, the volume change thereof due to swelling together with that of the hygroscopic layer 9 becomes large, and delamination is likely to occur. In contrast, if the thickness is too small, it is difficult to prolong the service life of the hygroscopic layer 9, by virtue of auxiliary moisture absorption.

### Ultraviolet Blocking Layer 15

As illustrated in FIGS. 1 to 3, an ultraviolet blocking layer 15 can be provided on a surface of either the metal foil (A) or the barrier sheet of the base material for mounting an electronic device, which is a surface on a side where the hygroscopic layer 9 is not laminated. The ultraviolet blocking layer 15 has a role of preventing ultraviolet rays from entering the inside of the base material and the device by reflecting ultraviolet rays or absorbing ultraviolet rays.

The range of wavelengths of ultraviolet rays to be reflected or absorbed by the ultraviolet blocking layer 15 is from 200 nm to 400 nm, preferably from 250 nm to 400 nm, and particularly preferably from 280 nm to 400 nm.

The ultraviolet transmittance of the ultraviolet blocking layer 15 is from 0.1% to 20%, preferably from 0.1% to 15%, and more preferably from 0.1% to 10%. In a case where the ultraviolet transmittance is less than 0.1%, the quality is excessive, which increases the cost. On the other hand, in a case where the ultraviolet transmittance exceeds 20%, deterioration of the base material or the electronic device proceeds.

The ultraviolet blocking layer 15 can be molded by a general thermoplastic resin, but is preferably formed of a resin such as a polycarbonate resin, a silicone resin, a polyester resin, a fluorine-based resin, or an acrylic resin, from the viewpoint of weather resistance and cost.

In the resin forming the ultraviolet blocking layer 15, carbon black that absorbs ultraviolet rays as an ultraviolet blocking agent or an inorganic pigment such as titanium oxide that scatters ultraviolet rays can be dispersed in the resin. In addition, in a case of absorbing ultraviolet rays, an additive such as a benzotriazole-based, benzophenone-based, or triazine-based additive can be dispersed in the resin as an organic ultraviolet absorber. In a case where the ultraviolet blocking layer 15 is formed of a resin, the ultraviolet blocking layer 15 and the protective resin layer 5 or the protective resin layer 11d are preferably bonded to each other by an adhesive layer 17 described below.

The ultraviolet blocking layer 15 may be formed by directly applying a coating material containing the ultraviolet blocking agent or the organic ultraviolet absorber onto the protective resin layer 5 or the protective resin layer 11d. In this case, it is possible to block the permeation of ultraviolet rays into the device by blocking or absorbing the whole or part of ultraviolet rays. As such a coating material, a fluorine-based, silicone-based, urethane-based, or acrylic coating material is suitably used.

### Adhesive Layer 17

The adhesive layer 17 is a layer for bonding the ultraviolet blocking layer 15 and the protective resin layer 5 or the protective resin layer 11d, and the same material as that of the adhesive layer 7 can be used.

### Application of Base Material

The base material for mounting an electronic device of the present invention can be produced by a method described in Examples described below. Such a base material 1 has an entire thickness of from 25 to 250 µm, preferably from 25 to 230 µm, and more preferably from 25 to 200 µm. When the entire thickness of the base material 1 is less than 25 µm, the strength of the entire base material is insufficient, and thus, breakage, perforation, or the like may occur. On the other hand, when the entire thickness of the base material 1 exceeds 250 µm, sufficient flexibility is not obtained, which makes handling difficult.

The electronic device is not particularly limited, and the base material of the present invention can be applied to all devices such as electronic devices that dislike leakage of charges due to the presence of moisture, for example, an organic EL element, a solar cell panel, and a touch panel.

Note that the method for installing the base material 1 is not particularly limited, and the base material 1 is installed by a method suitable for the intended use. For example, in a case where the base material of the present invention is used as a back sheet of a solar cell, the base material is fixed integrally with a cell or the like by a frame.

In a case of being used for an organic EL device or the like, the metal foil (A) 3 or the barrier sheet 11 can be coated with a known pressure-sensitive adhesive such as an acrylic, silicone-based, or butadiene-based pressure-sensitive adhesive, or can be attached to a device surface with a thermocompression bonding type sealing sheet such as an ethylene-vinyl acetate copolymer resin-based, polyvinyl butyral-based, or olefin-based sealing sheet, or a UV curable adhesive such as an epoxy-based or acrylic adhesive. In this aspect, when the hygroscopic ability of the hygroscopic layer 9 is lost, the base material can be peeled off and replaced.

The base material 1 of the present invention has the metal foil (A) 3 or the metal foil (B) 11c, and thus, is used on the surface of the above-mentioned device where light transmittance is not required, for example, a non-light-receiving surface of a back sheet or the like of a solar cell, a non-light-emitting surface of an organic electroluminescent element, side surfaces of various devices, and the like.

### Examples

### Fabrication of Inorganic Barrier Layer-Coated Polyethylene Terephthalate (PET) Film

A plasma CVD apparatus was used to form the inorganic barrier layer 11b of silicon oxide on one surface of a biaxially oriented PET film having a thickness of 25 µm as the resin layer 11a. The film forming conditions are indicated below.

A CVD apparatus was used in which a high-frequency output power source having a frequency of 27.12 MHz and a maximum output of 2 kW, a matching box, a metal-type cylindrical plasma processing chamber having a diameter of 300 mm and a height of 450 mm, and an oil rotary vacuum pump for evacuating the processing chamber are included. A PET film was placed on a parallel flat plate in the processing chamber, 3 sccm of hexamethyldisiloxane and 45 sccm of oxygen were introduced, and then high-frequency waves were oscillated by a high-frequency oscillator at an output of 50 W, and film forming was performed for 2 seconds to form an adhesion layer. Subsequently, high-frequency waves were oscillated by the high-frequency oscillator at an output of 200 W, and film forming was performed for 100 seconds to form silicon oxide, whereby an inorganic barrier layer-coated PET film was obtained as a barrier sheet 11. The resultant inorganic barrier layer-coated PET film was found to have a water vapor permeance of 1 × 10⁻² g/m²·day as measured under an atmosphere of 40°C and 90%RH.

### Preparation of Coating Liquid A for Fabricating Hygroscopic Layer 9

Polyallylamine (PAA-15C, available from Nittobo Medical Co., Ltd., an aqueous solution product, solid content: 15 wt.%) as an ionic polymer was diluted with water to have the solid content of 5 wt.%, thereby obtaining a polymer solution. On the other hand, γ-glycidoxypropyltrimethoxysilane was used as a crosslinking agent, and dissolved in water so as to be 5 wt.% to prepare a crosslinking agent solution. Subsequently, the polymer solution and the crosslinking agent solution were mixed in such a manner that the amount of γ-glycidoxypropyltrimethoxysilane was 15 parts by weight per 100 parts by weight of polyallylamine, and further, to this mixed solution was added a crosslinked product of sodium polyacrylate (TAFTIC HU-820E, available from Toyobo Co., Ltd., a water dispersion product, solid content: 13%) as a hygroscopic agent to be 400 parts by weight with respect to the polyallylamine, and the resulting mixture was further adjusted with water to have a solid content of 5%, and then well stirred to prepare a coating solution A for fabricating the hygroscopic layer 9.

### Fabrication of Base Material

The coating liquid A for fabricating the hygroscopic layer 9 prepared as described above was applied, by a bar coater, to the side of the inorganic barrier layer-coated PET film on which the inorganic barrier layer 11b had been formed. The applied film was heat-treated in a box-type electric oven under the conditions of a peak temperature of 120°C and a peak temperature retention time of 6 seconds to form an ionic polymer having a thickness of 3 µm as the hygroscopic layer 9, thereby obtaining a coating film A.

Subsequently, in a glove box in which a nitrogen concentration was adjusted to 99.95% or more, an aluminum foil of 15 µm as the metal foil (A) was dry-laminated onto the surface of the coating film A on which the hygroscopic layer 9 had been formed, with a urethane-based adhesive having a thickness of 2.0 µm interposed therebetween. Further, a PET film of 25 µm was dry-laminated as the protective resin layer 5 on the surface of the aluminum foil opposite to the surface on which the hygroscopic layer 9 was provided, with a urethane-based adhesive having a thickness of 2.0 µm interposed therebetween, thereby obtaining a base material A.

In addition, the thicknesses of the metal foil (A), the protective resin layer 5, the resin layer 11a, and the protective resin layer 11d were changed as appropriate, and the quasi-hygroscopic layer 13 and the ultraviolet blocking layer 15 were provided as necessary, thereby fabricating the base materials A to L shown in Table 1.

**[Table 1]**

| Substrate | Ultraviolet blocking layer | Protective resin layer | Metal foil | Quasi-hygroscopic layer | Hygroscopic layer | Barrier sheet |
|---|---|---|---|---|---|---|
| Base material A | None | PET (25 µm) | Aluminum foil (15 µm) | None | Hygroscopic material-dispersed ionic polymer (3 µm) | Metal oxide vapor deposition film PET (25 µm) |
| Base material B | None | PET (25 µm) | Aluminum foil (5 µm) | None | Hygroscopic material-dispersed ionic polymer (3 µm) | Metal oxide vapor deposition film PET (25 µm) |
| Base material C | None | PET (25 µm) | Aluminum foil (20 µm) | None | Hygroscopic material-dispersed ionic polymer (3 µm) | Metal oxide vapor deposition film PET (25 µm) |
| Base material D | None | PET (25 µm) | Aluminum foil (15 µm) | None | Hygroscopic material-dispersed ionic polymer (3 µm) | Aluminum foil (15 µm)/adhesive/PET (25 µm) |
| Base material E | None | PET (25 µm) | Aluminum foil (15 µm) | Nylon (25 µm) | Hygroscopic material-dispersed ionic polymer (3 µm) | Metal oxide vapor deposition film PET (25 µm) |
| Base material F | UV cut film (55 µm) | PET (25 µm) | Aluminum foil (15 µm) | None | Hygroscopic material-dispersed ionic polymer (3 µm) | Metal oxide vapor deposition film PET (25 µm) |
| Base material G | UV cut coating (10 µm) | PET (25 µm) | Aluminum foil (15 µm) | None | Hygroscopic material-dispersed ionic polymer (3 µm) | Metal oxide vapor deposition film PET (25 µm) |
| Base material H | None | PET (12 µm) | Aluminum foil (5 µm) | None | Hygroscopic material-dispersed ionic polymer (3 µm) | Metal oxide vapor deposition film PET (12 µm) |
| Base material I | None | PET (25 µm) | Aluminum foil (15 µm) | None | Hygroscopic material-dispersed ionic polymer (3 µm) | Metal oxide vapor deposition film PET (200 µm) |
| Base material J | None | PET (25 µm) | Aluminum foil (20 µm) | None | Hygroscopic material-dispersed ionic polymer (3 µm) | Metal oxide vapor deposition film PET (250 µm) |
| Base material K | None | PET (25 µm) | Aluminum foil (25 µm) | None | Hygroscopic material-dispersed ionic polymer (3 µm) | Metal vapor deposition film PET (25 µm) |
| Base material L | None | PET (25 µm) | Aluminum foil (25 µm) | None | Hygroscopic material-dispersed ionic polymer (3 µm) | Aluminum foil (15 µm)/adhesive/PET (25 µm) |

### Experimental Example 1

### Calcium Corrosion Method (No Bending Test)

The influence of moisture permeation on the base material A fabricated above was measured by a calcium corrosion method (JIS K7129-7).

Under an inert gas atmosphere, a calcium film was formed to be 100 nm on a surface of a glass base material, and then a pressure-sensitive adhesive was attached thereto. Thereafter, the inorganic barrier layer-coated PET film of the base material A was bonded to the pressure-sensitive adhesive adhesive in such a manner that the surface of the PET film was in contact with the adhesive, thereby fabricating a cell for evaluation.

The cell for evaluation was stored in a thermo-hygrostat at 40°C and 90%RH for 1000 hours, and then, the state of the calcium thin film was observed from a glass substrate side with a microscope. Evaluation criteria are as follows. The results are shown in Table 2.

### Evaluation Criteria

○: No corrosion of calcium film was observed
×: Corrosion of calcium film was confirmed

### Calcium Corrosion Method (with Bending Test)

The base material A was subjected to a bending test of 10000 times in each of both bending directions at a diameter of 5 mm using a desktop-type durability tester (available from Yuasa System Co., Ltd.) under an environment of 23°C and 50%RH. A cell for evaluation was fabricated in the same manner as described above for the base material A after the bending test.

The cell for evaluation was stored in a thermo-hygrostat at 40°C and 90%RH for 1000 hours, and then, the state of the calcium thin film was observed from a glass substrate side with a microscope. Evaluation criteria are as described above. The results are shown in Table 2.

### Experimental Example 2

Measurement by the calcium corrosion method was performed in the same manner as in Experimental Example 1 except that the base material A was changed to the base material B.

### Experimental Example 3

Measurement by the calcium corrosion method was performed in the same manner as in Experimental Example 1 except that the base material A was changed to the base material C.

### Experimental Example 4

Measurement by the calcium corrosion method was performed in the same manner as in Experimental Example 1 except that the surface of the base material A to be bonded to the pressure-sensitive adhesive adhesive was changed to a surface of a PET film of 25 µm as the protective resin layer 5.

### <Experimental Example 5>

Measurement by the calcium corrosion method was performed in the same manner as in Experimental Example 1 except that the base material A was changed to the base material D.

### <Experimental Example 6>

In a glove box in which a nitrogen concentration was adjusted to 99.95% or more, a nylon film of 25 µm as the quasi-hygroscopic layer 13 was dry-laminated onto the surface of the coating film A on which the hygroscopic layer 9 had been formed, with a urethane-based adhesive having a thickness of 2.0 µm interposed therebetween. Further, an aluminum foil of 15 µm was dry-laminated as the metal foil (A) on the surface of the nylon film opposite to the surface on which the hygroscopic layer 9 was provided, with a urethane-based adhesive having a thickness of 2.0 µm interposed therebetween. Further, a PET film of 25 µm as the protective resin layer 5 was dry-laminated on the surface of the aluminum foil opposite to the surface on which the quasi-hygroscopic layer 13 was provided, with a urethane-based adhesive having a thickness of 2.0 µm interposed therebetween, thereby obtaining the base material E. Measurement by the calcium corrosion method was performed in the same manner as in Experimental Example 1.

### Experimental Example 7

A UV cut film (55 µm) of an acrylic resin was dry-laminated as the ultraviolet blocking layer 15 on the surface of the protective resin layer 5 of the base material A with a urethane-based adhesive having a thickness of 2.0 µm, thereby fabricating the base material F. Measurement by the calcium corrosion method was performed in the same manner as in Experimental Example 1.

### Experimental Example 8

A fluorine-based UV cut coating layer (10 µm) was formed as the ultraviolet blocking layer 15 on the surface of the protective resin layer 5 of the base material A, thereby fabricating the base material G. Measurement by the calcium corrosion method was performed in the same manner as in Experimental Example 1.

### Experimental Example 9

Measurement by the calcium corrosion method was performed in the same manner as in Experimental Example 1 except that the base material A was changed to the base material H.

### Experimental Example 10

Measurement by the calcium corrosion method was performed in the same manner as in Experimental Example 1 except that the base material A was changed to the base material I.

### Experimental Example 11

Measurement by the calcium corrosion method was performed in the same manner as in Experimental Example 1 except that the base material A was changed to the base material J.

### Experimental Example 12

Measurement by the calcium corrosion method was performed in the same manner as in Experimental Example 1 except that the base material A was changed to the base material K.

### Experimental Example 13

Measurement by the calcium corrosion method was performed in the same manner as in Experimental Example 1 except that the base material A was changed to the base material L.

**[Table 2]**

| | Type of base material | Thickness of metal foil | Total thickness of base material | Ca evaluation (No bending test) | Ca evaluation (With bending test) | Base material appearance after bending test |
|---|---|---|---|---|---|---|
| Experimental Example 1 | Base material A | 15 µm | 72 µm | ○ | ○ | Good |
| Experimental Example 2 | Base material B | 5 µm | 62 µm | ○ | ○ | Good |
| Experimental Example 3 | Base material C | 20 µm | 77 µm | ○ | ○ | Good |
| Experimental Example 4 | Base material A | 15 µm | 72 µm | ○ | ○ | Good |
| Experimental Example 5 | Base material D | 15 µm | 89 µm | ○ | ○ | Good |
| Experimental Example 6 | Base material E | 15 µm | 99 µm | ○ | ○ | Good |
| Experimental Example 7 | Base material F | 15 µm | 129 µm | ○ | ○ | Good |
| Experimental Example 8 | Base material G | 15 µm | 82 µm | ○ | ○ | Good |
| Experimental Example 9 | Base material H | 5 µm | 36 µm | ○ | ○ | Good |
| Experimental Example 10 | Base material I | 15 µm | 247 µm | ○ | ○ | Good |
| Experimental Example 11 | Base material J | 20 µm | 302 µm | ○ | ○ | With fold |
| Experimental Example 12 | Base material K | 25 µm | 82 µm | ○ | × | - |
| Experimental Example 13 | Base material L | 25 µm | 99 µm | ○ | × | - |

In the calcium corrosion method (with bending test), no calcium corrosion was observed in any of the base materials A to I, and the base material appearance after the bending test was also good. That is, it can be said that all of the base materials A to I are base materials having both moisture barrier properties and flexibility.

On the other hand, in the base material J, although no corrosion of the calcium film was observed, a fold was generated in the appearance. It is considered that the base material J had a large total thickness of the base material and insufficient flexibility, and thus a fold was generated in the bending test.

In addition, corrosion of the calcium film was observed in the base materials K and L. It is considered that, the base materials K and L each had a large thickness of the metal foil (A) and insufficient flexibility, and thus, a large number of pinholes were generated in the metal foil by the bending test, whereby a large amount of moisture permeated and the hygroscopic resin layer swelled in a short period of time, and the moisture that was not absorbed reached the calcium film.

### Reference Signs List

1: Base material for mounting an electronic device
3: Metal foil (A)
5: Protective resin layer
7: Adhesive layer
9: Hygroscopic layer
11: Barrier sheet
11a: Resin layer
11b: Inorganic barrier layer
11c: Metal foil (B)
11d: Protective resin layer
11e: Adhesive layer
13: Quasi-hygroscopic layer
15: Ultraviolet blocking layer
17: Adhesive layer

## Claims

1. A base material for mounting an electronic device, the base material comprising a metal foil (A), a hygroscopic layer, and a barrier sheet laminated in this order, wherein
the metal foil (A) has a thickness of from 5 to 20 µm.

2. The base material for mounting an electronic device according to claim 1, wherein the metal foil (A) is formed of aluminum.

3. The base material for mounting an electronic device according to claim 1, wherein the hygroscopic layer comprises a resin composition in which a hygroscopic agent (ii) is dispersed in an ionic polymer (i).

4. The base material for mounting an electronic device according to claim 1, wherein the barrier sheet comprises a resin layer, and has an inorganic barrier layer on at least one surface of the resin layer.

5. The base material for mounting an electronic device according to claim 4, wherein the resin layer is formed of at least one of an olefin-based resin, a polyester resin, a polyimide resin, a polyamide resin, or a cyclic olefin-based resin.

6. The base material for mounting an electronic device according to claim 4, wherein the inorganic barrier layer is a vapor deposition film of a metal or a metal oxide.

7. The base material for mounting an electronic device according to claim 1, wherein the barrier sheet has a metal foil (B) formed of aluminum, and the metal foil (B) has a thickness of from 5 to 20 µm.

8. The base material for mounting an electronic device according to claim 1, wherein a quasi-hygroscopic layer is provided in at least one of a portion between the metal foil (A) and the hygroscopic layer or a portion between the hygroscopic layer and the barrier sheet.

9. The base material for mounting an electronic device according to claim 8, wherein the quasi-hygroscopic layer is formed of at least one of an ionic polymer, a polyamide resin, a polyvinyl alcohol-based resin, or an ethylene-vinyl alcohol copolymer resin.

10. The base material for mounting an electronic device according to claim 1, wherein an ultraviolet blocking layer is provided on a surface of either the metal foil (A) or the barrier sheet, the surface being on a side where the hygroscopic layer is not laminated.

11. The base material for mounting an electronic device according to claim 1, having a total thickness of from 25 to 250 µm.
